# EUROPEAN PATENT SPECIFICATION

(11) **EP 2 919 263 B1**
(45) Date of publication and mention of the grant of the patent: **18.08.2021**
(21) Application number: 13852845.0
(22) Date of filing: 08.11.2013
(51) Int. Cl.: H01L 23/02, H01L 23/06, H03H 9/02, H03H 9/10

(54) **COVER MATERIAL FOR HERMETIC SEALING OF A PACKAGE**
ABDECKMATERIAL FÜR HERMETISCHE DICHTUNG EINER VERPACKUNG
MATÉRIAU DE RECOUVREMENT POUR SCELLEMENT HERMÉTIQUE D'UN EMBALLAGE

(30) Priority: 12.11.2012 JP 2012248261
(43) Date of publication of application: 16.09.2015
(73) Proprietor: Hitachi Metals, Ltd., Tokyo 108-8224 (JP)
(72) Inventor: YOKOTA, Masayuki, Suita-shi Osaka 564-0043 (JP); YAMAMOTO, Masaharu, Suita-shi Osaka 564-0043 (JP)
(74) Representative: Hoffmann Eitle
(86) International application number: PCT/JP2013/080321
(87) International publication number: WO 2014/073665

(56) References cited:
- WO-A1-2012/108083
- JP-A- 2000 236 228
- JP-A- 2002 026 679
- JP-A- 2002 255 167
- JP-A- 2002 255 167
- JP-A- 2009 232 327
- US-A1- 2012 132 522

## Description

### Technical Field

The present invention relates to a cover material for hermetic sealing and a package for containing an electronic component employing the same.

### Background Art

A package for containing an electronic component employing a cover material for hermetic sealing is known in general. Such a package for containing an electronic component is disclosed, for example, in JP-A-2012-74807.

In JP-A-2012-74807 , a piezoelectric vibrator including a piezoelectric vibrating element, a package body (electronic component containing member) consisting of an insulating substrate having a recess portion in which the piezoelectric vibrating element is contained and a sealing ring made of Kovar arranged on a peripheral edge of an upper portion of the insulating substrate and a cover member (cover material for hermetic sealing) seam-welded to the sealing ring is disclosed. The cover member of this piezoelectric vibrator is made of an Ni-plated Kovar material (29Ni-16Co-Fe alloy).

When manufacturing the cover member, it is general to manufacture the same by press-working and bringing the Kovar material into prescribed dimensions and thereafter performing Ni plating on the surface of the Kovar material, in order to form an Ni plating layer on the whole surface of the Kovar material. As methods of forming Ni plating on the surface of the Kovar material, there are electroless Ni plating and electrolytic Ni plating.

JP-A-2002-026679 discloses a package for a piezoelectric vibrating device, comprising a ceramic base on which a piezoelectric vibrating element is mounted and a metal lid hermetically sealing the mounted piezoelectric vibrating element in a cavity. The metal lid may comprise a Ni-Fe-Cr alloy plated with nickel. A_2012-132522 relates to a method for hermetically sealing a microdevice in a cavity using a lid of Ni-Fe-Cr alloy coated with nickel on the side facing the cavity.

JP-A-2002-255167 describes an electronic part package equipped with a first packaging material 12 made of metal or ceramic and a lid 14 including a shape retaining section 14a made of Ni-Fe-Cr both side of which are coated with a nickel layer.

### Summary of the Invention

### Problems to be Solved by the Invention

In a case of performing electroless Ni plating on the surface of the Kovar material, however, a plurality of cover members plated in a barrel so overlap with each other that the thickness of Ni plating is easily dispersed. Thus, there is inconveniently a case where sufficient hermetic sealing cannot be performed due to dispersion in the thickness of the Ni plating at a time of welding the cover members and sealing rings to each other. When performing the electroless Ni plating on the surface of the Kovar material, therefore, it is necessary to introduce a dummy member for preventing overlapping of the plurality of cover members into the barrel, in order to prevent the thickness of the Ni plating from dispersion. Therefore, the number of cover members platable in the barrel at once decreases. Consequently, the time required for the electroless Ni plating per cover member lengthens.

Also in a case of performing the electrolytic Ni plating on the surface of the Kovar material, the thickness of Ni plating is easily dispersed as the plating speed is increased by increasing the current density at the time of the plating. Thus, there is inconveniently a case where sufficient hermetic sealing cannot be performed due to dispersion in the thickness of the Ni plating at a time of welding cover members and sealing rings to each other, similarly to the electroless Ni plating. When performing the electrolytic Ni plating on the surface of the Kovar material, therefore, it is necessary to reduce the plating speed by reducing the current density at the time of the plating, in order to prevent the thickness of the Ni plating from dispersion. Therefore, the time required for the electrolytic Ni plating per cover member lengthens.

Whichever one of the electroless Ni plating and the electrolytic Ni plating is performed, it is necessary to prevent corrosion of the cover members with a plating solution by sufficiently washing the cover members after the Ni plating. Therefore, the time required for the Ni plating per cover member further lengthens.

As a result of these, there is such a problem that the time required for the Ni plating per cover member so lengthens that the time (tact time) necessary for manufacturing one cover member lengthens in the piezoelectric vibrator disclosed in JP-A-2012-74807 .

In a case where the thickness of the Ni plating is dispersed, there is a case where the surface of the Kovar material is exposed. In this case, the Kovar material is corroded from a portion not covered with the Ni plating, and hence there is also such a problem that the corrosion resistance of the cover members lowers.

The present invention has been proposed in order to solve the aforementioned problems, and an object of the present invention is to provide a cover material for hermetic sealing capable of preventing corrosion resistance from lowering while preventing a time (tact time) necessary for manufacturing one cover material for hermetic sealing from lengthening and a package for containing an electronic component employing the same.

### Means for Solving the Problems

The present invention provides a material which is suitable as a cover material [1] for hermetic sealing and is constituted of a three-layer clad material comprising:
(i) a base material layer [10] made of a Ni-Cr-Fe alloy containing 36-48 mass-% of Ni, 1-10 mass-% of Cr and Fe, or a Ni-Cr-Co-Fe alloy containing 36-48 mass-% of Ni, 1-10 mass-% of Cr, 6-18 mass-% of Co and Fe;
(ii) a first surface layer [11] made of a Ni-Cu alloy containing ≥ 30 mass% Ni, Cu and unavoidable impurities and bonded to one surface of the base material layer [10]; and
(iii) a second surface layer [12] made of a Ni-Cu alloy containing ≥ 30 mass% Ni, Cu and unavoidable impurities and bonded to the other surface of the base material layer [10;
and the layers [11] and [12] have a thickness of 2-6 µm.

Also, the present invention provides a package [100] suitable for containing an electronic component comprising a member [30] for containing an electronic component; and the material of the invention as a cover material [1]. Further provided is the use of the present material as a cover material [1] of a package [100] suitable for containing an electronic component.

Preferred embodiments of the invention are as defined in the appended dependent claims and/or in the following detailed description.

In the present material, the base material layer [10] is so made of an Ni-Cr-Fe alloy or an Ni-Cr-Co-Fe alloy that a passive state film mainly consisting of Cr₂O₃ is formed on the surface of the base material layer, whereby the corrosion resistance of the base material layer can be more improved than in a case where the base material layer is made of Kovar (29Ni-16Co-Fe alloy). Thus, the base material layer can be prevented from corroding from a portion not covered with the surface layer made of an Ni alloy, whereby the corrosion resistance of the cover material for hermetic sealing can be prevented from lowering.

The base material layer is made of an Ni-Cr-Fe alloy or an Ni-Cr-Co-Fe alloy containing 1-10 mass % of Cr. In this case, a passive state film mainly consisting of Cr₂O₃ is reliably formed on the surface of the base material layer by setting the content of Cr in the base material layer to at least 1 mass %, whereby the corrosion resistance of the base material layer can be more improved. Further, the thermal expansion coefficient of the base material layer can be prevented from enlarging by setting the content of Cr in the base material layer to not more than 10 mass %, whereby thermal expansion difference between the electronic component containing member made of ceramics, for example, and the present material can be prevented from enlarging. Thus, thermal stress generated between the present material and the electronic component containing member can be reduced, whereby the package for containing an electronic component can be prevented from breaking due to thermal stress.

Preferably, the base material contains 6-10 mass % of Cr. In this case, a passive state film mainly consisting of Cr₂O₃ is more reliably formed on the surface of the base material layer, whereby the corrosion resistance of the base material layer can be more improved.

Preferably, the base material layer is made of an Ni-Cr-Co-Fe alloy containing 6-18 mass % of Co. In this case, the thermal expansion coefficient of the base material layer can be prevented from enlarging by setting the content of Co in the base material layer to 6-18 mass %, whereby thermal expansion difference between the electronic component containing member made of ceramics, for example, and the present material can be prevented from enlarging. Thus, thermal stress generated between the present material and the electronic component containing member can be reduced, whereby the package for containing an electronic component can be prevented from breaking due to thermal stress.

In the present material, the surface layers [11], [12] are made of an Ni-Cu alloy containing Ni and Cu. In this case, the melting point of the surface layer can be lowered as compared with a case where the surface layer is made of Ni or a case where the same is made of another Ni alloy, whereby the temperature at the time of bonding between the present material and the electronic component containing member can be lowered. Thus, thermal stress generated between the present material and the electronic component containing member can be reduced.

The surface layers are made of an Ni-Cu alloy containing at least 30 mass % of Ni. In this case, Ni excellent in corrosion resistance is sufficiently contained in the surface layer, whereby the corrosion resistance of the surface layer can be sufficiently ensured.

Preferably, the surface layers are made of an Ni-Cu alloy containing at least 60 mass % of Ni. In this case er, Ni is further sufficiently contained in the surface layer, whereby not only the corrosion resistance but also oxidation resistance can be effectively improved in the surface layer. Thus, the surface layer can be reliably prevented from oxidation also in a case where heat treatment is performed in the atmosphere.

The surface layers have a thickness of 2-6 µm. In this case, hermetic sealing of the package for containing an electronic component can be more prevented from becoming difficult, and the ratio of the surface layer not contributing to the bonding can be sufficiently reduced.

The first surface layer and the second surface layer made of an Ni-Cu alloy containing Ni and Cu are arranged on the front and rear sides of the present material respectively, whereby either one of both surfaces of the present material can be bonded to the electronic component containing member. Thus, workability in the bonding between the present material and the cover material for hermetic sealing can be improved.

Preferably in this case, the second surface layer is made of the same metallic material as the first surface layer, whereby the front and rear sides of the present material may not be distinguished from each other. Thus, workability in the bonding between the present material and the electronic component containing member can be more improved.

Preferably, the clad material includes a silver solder layer at least bonded onto a surface of the surface layer on the side of the electronic component containing member. In this case, the present material and the electronic component containing member can be sealed with the silver solder layer without employing a sealing ring formed with e.g. silver solder, whereby the number of components can be reduced when preparing the package for containing an electronic component. Further, the package for containing an electronic component can be miniaturized due to the non-provision of the sealing ring.

Preferably in the aforementioned structure in which the second surface layer is made of the same metallic material as the first surface layer, the base material layer is made of an Ni-Cr-Fe alloy containing 36-48 mass % of Ni, 1-10 mass % of Cr and Fe. In this case, a time (tact time) necessary for manufacturing one present material can be reliably prevented from lengthening while reliably ensuring the corrosion resistance of the present material by setting the content of Cr in the base material layer to at least 1 mass %.

Preferably, if the base material layer is an Ni-Cr-Fe alloy, the base material layer is made of an Ni-Cr-Fe alloy containing 36-48 mass % of Ni, 6-10 mass % of Cr and Fe. In this case, the tact time can be more reliably prevented from lengthening while more reliably ensuring the corrosion resistance of the present material by setting the content of Cr in the base material layer to at least 6 mass %. Further, the surface layer is so made of an Ni-Cu alloy that the melting point of the surface layer can be lowered as compared with a case where the surface layer is made of Ni, whereby the temperature at the time of bonding between the present material for hermetic sealing and the electronic component containing member can be lowered. Thus, thermal stress generated between the present material and the electronic component containing member can be reduced.

If the base material layer is made of an Ni-Cr-Co-Fe alloy containing 1-10 mass % of Cr, 6-18 mass % of Co and Fe, the time (tact time) necessary for manufacturing one present material can be reliably prevented from lengthening while reliably ensuring the corrosion resistance of the present material by setting the content of Cr in the base material layer to at least 1 mass %. Further, the thermal expansion coefficient of the base material layer can be prevented from enlarging by setting the content of Co in the base material layer to 6-18 mass %, whereby the thermal expansion difference between the electronic component containing member made of ceramics, for example, and the present material can be prevented from enlarging. Thus, thermal stress generated between the present material and the electronic component containing member can be reduced, whereby the package for containing an electronic component can be prevented from breaking due to thermal stress.

Preferably, the surface layer bonded to the surface of the base material layer on the side of the electronic component containing member is configured to function as a melting bonding layer when resistance-welded with respect to the electronic component containing member. In this case, the present material including the surface layer functioning as a bonding layer and the electronic component containing member can be easily bonded to each other by resistance welding.

A package [100] for containing an electronic component (the present package) includes a member for containing an electronic component and the present material resistance-welded with respect to the present package.

The present package can prevent the base material layer of the present from corroding from a portion not covered with the surface layer made of Ni or an Ni alloy, whereby the corrosion resistance of the present material can be prevented from lowering.

Preferably in the present package, the surface layer bonded to the surface of the base material layer on the side of the electronic component containing member functions as a melting bonding layer when resistance-welded with respect to the present package. In this case, the present material including the surface layer functioning as a bonding layer and the electronic component containing member can be easily bonded to each other by resistance welding.

### Effect of the Invention

According to the present invention, as hereinabove described, the corrosion resistance of the present material can be prevented from lowering while preventing the time (tact time) necessary for manufacturing one present material from lengthening.

### Brief Description of the Drawings

[Fig. 1] A perspective view showing the structure of one embodiment of the present material.
[Fig. 2] A sectional view along the line 400-400 in Fig. 1.
[Fig. 3] A perspective view showing the structure of an embodiment of the present package.
[Fig. 4] A sectional view along the line 500-500 in Fig. 3.
[Fig. 5] A perspective view showing the structure of an electronic component containing member.
[Fig. 6] A perspective view for illustrating a manufacturing process for the present package.
[Fig. 7] A table showing results of a corrosion resistance test of present materials conducted to confirm effects of the present invention.
[Fig. 8] A table showing results of a seam welding test (fixed condition test) conducted to confirm effects of the present invention.
[Fig. 9] A table showing results of a seam welding test (varied condition test) conducted to confirm effects of the present invention.
[Fig. 10] A table showing results of leak tests and reliability tests of Example 1 conducted to confirm effects of the present invention.
[Fig. 11] A table showing results of leak tests and reliability tests of Examples 3-6 conducted to confirm effects of the present invention.
[Fig. 12] A table showing results of a corrosion resistance test of Ni-Cu alloys conducted to confirm effects of the present invention.
[Fig. 13] A table showing results of an oxidation resistance test of Ni-Cu alloys conducted to confirm effects of the present invention.
[Fig. 14] A graph showing results of an oxidation resistance test of Ni-Cu alloys conducted to confirm effects of the present invention.
[Fig. 15] A graph of thermal expansion coefficients for studying the composition of a base material layer.
[Fig. 16] A table of thermal expansion coefficients for studying the composition of the base material layer according to one embodiment of the present invention.
[Fig. 18] A sectional view showing the structure of a second modification of the present material.
[Fig. 19] A sectional view showing the structure of a second modification of the present package.

### Modes for Carrying Out the Invention

An embodiment embodying the present invention is now described on the basis of the drawings.

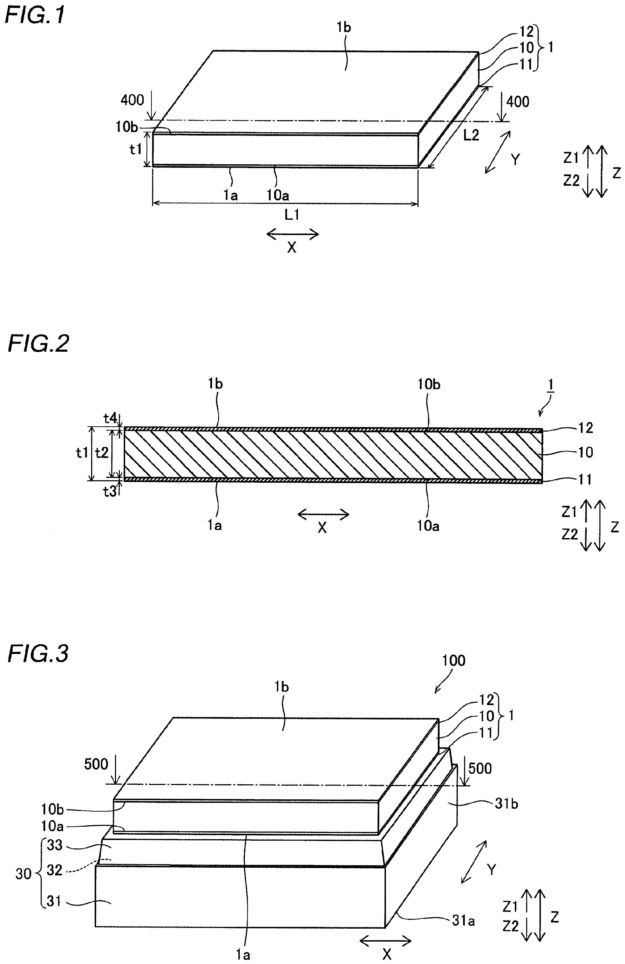

First, the structure of the present material 1 is described with reference to Figs. 1 and 2.

The material 1 is employed for a present package 100 including a member 30 for containing a crystal unit 20 described later. The material 1 has a length L1 of 2.3 mm in the longitudinal direction (X direction), a length L2 of 1.8 mm in the short-side direction (Y direction) and a thickness t1 of 80 µm in the thickness direction (Z direction), as shown in Fig. 1.

The material 1 consists of a three-layer clad material constituted of a base material layer 10 and surface layers 11 and 12 pressure-bonded to a lower surface 10a (the surface on a Z2 side) and an upper surface 10b (the surface on a Z1 side) of the base material layer 10 respectively, as shown in Fig. 2. The surface layers 11 and 12 are arranged on the side of a lower surface 1a and the side of an upper surface 1b of the material 1 respectively. The surface layer 11 arranged on the side of the lower surface 1a of this material 1 functions as a melting bonding layer when welded with respect to the electronic component containing member 30 by seam welding which is a sort of resistance welding. The surface layers 11 and 12 are examples of the "first surface layer" and the "second surface layer" in the present invention respectively, while the lower surface 10a and the upper surface 10b are examples of "one surface" and "another surface" in the present invention respectively.

According to this embodiment, the base material layer 10 is made of an Ni-Cr-Fe alloy consisting of Ni, Cr, Fe and unavoidable impurities or an Ni-Cr-Co-Fe alloy consisting of Ni, Cr, Co, Fe and unavoidable impurities. The content of Ni in the Ni-Cr-Fe alloy or the Ni-Cr-Co-Fe alloy constituting the base material layer 10 is 36-48 mass %, and preferably in the vicinity of 42 mass %. The content of Cr in the Ni-Cr-Fe alloy or the Ni-Cr-Co-Fe alloy is 1-10 mass %, and preferably 4-10 mass %. Further preferably, the content of Cr is 6-10 mass %. In the case where the base material layer 10 is made of the Ni-Cr-Co-Fe alloy, the content of Co is 6-18 mass %. The base material layer 10 is further preferably made of an Ni-Cr-Co-Fe alloy.

In view of lowering of the melting point, the surface layers 11 and 12 are made of an Ni-Cu alloy containing at least 30 mass % of Ni and not more than 70 mass % of Cu. In view of attaining oxidation resistance, the surface layers 11 and 12 are preferably made of an Ni-Cu alloy containing at least 45 mass % of Ni and not more than 55 mass % of Cu, and more preferably containing at least 60 mass % of Ni and not more than 40 mass % of Cu.

The material 1 preferably consists of the three-layer clad material constituted of the base material layer 10 made of an Ni-Cr-Fe alloy or an Ni-Cr-Co-Fe alloy and the surface layers 11 and 12 made of an Ni-Cu alloy containing at least 30 mass % of Ni. Further, the base material layer 10 preferably contains 4-10 mass %, more preferably6-10 mass %, of Cr.

Cr in the Ni-Cr-Fe alloy constituting the base material layer 10 is so oxidized that passive state films mainly consisting of Cr₂O₃ are formed at least on portions of side surfaces of the material 1 on which the base material layer 10 is exposed. Thus, the material 1 is so configured that the corrosion resistance of the base material layer 10 improves.

The base material layer 10 has a thickness t2 of 74 µm, the surface layer 11 has a thickness t3 of 3 µm, and the surface layer 12 has a thickness t4 of 3 µm. The thickness t3 of the surface layer 11 is 2-6 µm. preferably 3-4 µm. To bring the front and rear sides of the material 1 into the same structure, the thickness t3 of the surface layer 11 and the thickness t4 of the surface layer 12 are preferably the same.

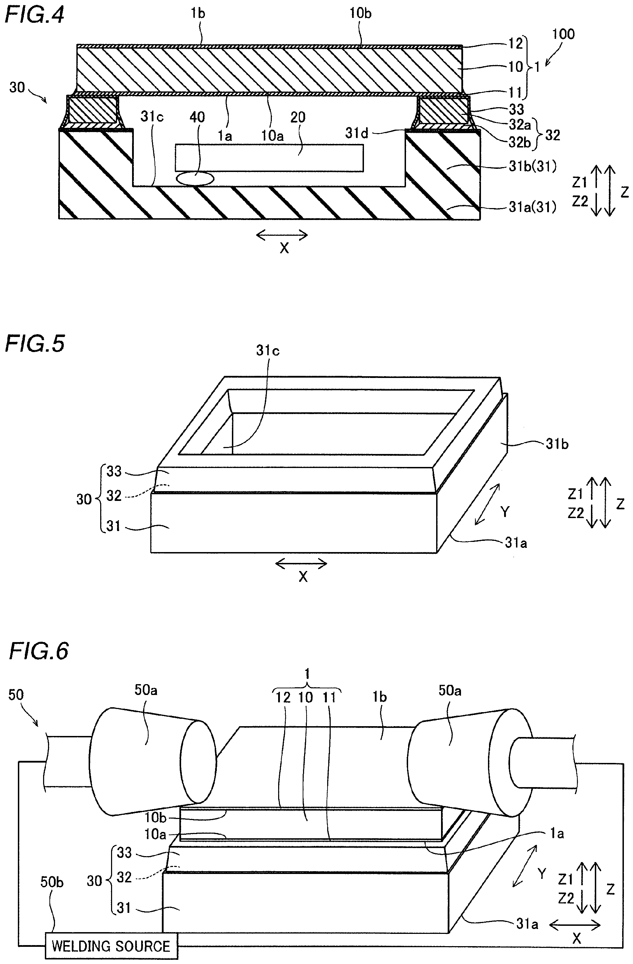

The structure of the package 100 for which the present material 1 is employed is now described with reference to Figs. 3 and 4.

The package 100 according to this embodiment includes the material 1 and the electronic component containing member 30 hermetically sealed by the material 1 in a state containing the crystal unit 20 (see Fig. 4), as shown in Figs. 3 and 4. In the package 100, the material 1 is so arranged on the member 30 that the surface layer 11 of the material 1 is on the side (the lower side, the Z2 side) of the member 30. The crystal unit 20 is an example of the "electronic component" in the present invention.

The member 30 includes a box-shaped base 31 made of alumina (Al₂O₃) which is ceramics, a ring-shaped sealing ring 32 brazed/bonded to the base 31 and a protective plating layer 33 covering the sealing ring 32.

The base 31 includes a bottom portion 31a on the Z2 side and a side portion 31b formed to extend upward (toward the Z1 side) from the outer peripheral edge of the upper surface (the surface on the Z1 side) of the bottom portion 31a, as shown in Fig. 4. A recess portion 31c is formed on the member 30, to be surrounded by the bottom portion 31a and the side portion 31b. The crystal unit 20 is contained in the recess portion 31c in a state fixed to the recess portion 31c with a bump 40.

A metallized layer 31d is formed on an upper end of the side portion 31b. This metallized layer 31d is so formed as to render brazing/bonding between the ceramics (Al₂O₃) constituting the base 31 and metal (Kovar) constituting the sealing ring 32 excellent. The metallized layer 31d has such a structure that a W layer, an Ni layer and an Au layer (not shown) are stacked in this order from the upper end of the side portion 31b upward (toward the side of the sealing ring 32, the Z1 side).

The sealing ring 32 made of metal has a base material 32a made of Kovar (29Ni-16Co-Fe alloy) and a silver solder portion 32b arranged on at least the lower surface of the base material 32a. Heat is applied in a state where the metallized layer 31d of the base 31 and the silver solder portion 32b of the sealing ring 32 are in contact with each other, whereby the silver solder portion 32b is molten. Thus, the base 31 and the sealing ring 32 are brazed/bonded to each other. Further, the protective plating layer 33 consisting of an Ni plating layer and an Au plating layer (not shown) is formed to cover the sealing ring 32 in the state where the base 31 and the sealing ring 32 are brazed/bonded to each other.

The material 1 is welded by seam welding which is a sort of resistance welding to be bonded with respect to the member 30 in a state arranged on the upper surface of the sealing ring 32 of the member 30. In other words, the surface layer 11 of the material 1 is so molten by the seam welding that the material 1 is bonded to the upper surface of the sealing ring 32.

A manufacturing process for the package 100 according to one embodiment of the invention is now described with reference to Figs. 1-6.

First, a base material (not shown) made of an Ni-Cr-Fe alloy and a pair of surface materials (not shown) made of an Ni-Cu alloy are prepared, and the surface materials are arranged on both surfaces of the base material respectively. The ratios between the thickness of the surface material, the thickness of the base material and the thickness of the surface material are about 4:92:4. Then, a clad material (not shown) in which the surface materials are bonded to both surfaces of the base material respectively is prepared by rolling/working the base material and the pair of surface materials by employing a rolling mill (not shown). At this time, the clad material is rolled until the thickness t1 (see Fig. 2) of the clad material becomes 80 µm, whereby the thickness t2 (see Fig. 2) of the base material layer 10 becomes 74 µm, while the thickness t3 (see Fig. 2) of the surface layer 11 and the thickness t4 (see Fig. 2) of the surface layer 12 both become 3 µm.

Thereafter the clad material is punch-worked (press-worked) into a rectangular shape of the length L1 (see Fig. 1) of 2.3 mm in the longitudinal direction (X direction) and the length L2 (see Fig. 1) of 1.8 mm in the short-side direction (Y direction). Thus, the material 1 consisting of the three-layer clad material constituted of the base material layer 10 and the surface layers 11 and 12 pressure-bonded to the lower surface 10a (the surface on the Z2 side) and the upper surface 10b (the surface on the Z1 side) of the base material layer 10 respectively is manufactured, as shown in Figs. 1 and 2. In this material 1 consisting of the three-layer clad material, there is no need to perform Ni plating.

Further, the base 31 and the sealing ring 32 are prepared, as shown in Fig. 5. Then, the base 31 and the sealing ring 32 are arranged in a vacuum furnace (not shown) in a state bringing the metallized layer 31d (see Fig. 4) of the base 31 and the silver solder portion 32b (see Fig. 4) of the sealing ring 32 into contact with each other. Then, the silver solder portion 32b is molten at a prescribed temperature, thereby brazing/bonding the base 31 and the sealing ring 32 to each other. Thereafter the member 30 is manufactured by forming the protective plating layer 33 to cover the sealing ring 32.

Then, the material 1 is arranged on the upper surface of the sealing ring 32 in a state containing the crystal unit 20 (see Fig. 4) in the member 30, as shown in Fig. 6. Then, the material 1 and the member 30 are bonded to each other by seam welding. More specifically, a pair of roller electrodes 50a of a seam welding machine 50 are arranged on a peripheral edge portion of the material 1. Then, the pair of roller electrodes 50a are moved in the X direction or in the Y direction at a prescribed welding speed along the peripheral edge portion of the material 1 while feeding current from a welding source 50b at a prescribed output under a nitrogen atmosphere or under a vacuum atmosphere. Thus, heat is generated on bonded regions of the surface layer 11 arranged on the side of the lower surface 1a of the material 1 and the upper surface of the sealing ring 32 of the member 30. Consequently, the surface layer 11 functioning as a bonding layer is molten, and the material 1 is welded with respect to the member 30. Consequently, the package 100 shown in Figs. 3 and 4 is manufactured.

According to this embodiment, as hereinabove described, the material 1 is configured to consist of the three-layer clad material constituted of the base material layer 10 made and the surface layers 11 and 12 pressure-bonded to the lower surface 10a and the upper surface 10b of the base material layer 10 respectively. Thus, there is no need to perform Ni plating on the surface of the base material layer 10. Consequently, a time (tact time) necessary for manufacturing one cover material 1 for hermetic sealing can be prevented from lengthening and a necessary cost can be prevented from enlarging as compared with a case of performing Ni plating.

According to this embodiment, the base material layer 10 is so made that passive state films mainly consisting of Cr₂O₃ are formed on the side surfaces where the base material layer 10 is exposed, whereby the corrosion resistance of the base material layer 10 can be more improved than in a case where the base material layer 10 is made of Kovar (29Ni-16Co-Fe alloy). Thus, the base material layer 10 can be prevented from corroding from side surfaces of the base material layer 10 not covered with the surface layers 11 and 12, whereby the corrosion resistance of the cover material 1 for hermetic sealing can be prevented from lowering.

Preferably, the base material layer 10 is made of an Ni-Cr-Fe alloy or an Ni-Cr-Co-Fe alloy approximately containing 6-10 mass % of Cr. Thus, passive state films mainly consisting of Cr₂O₃ are reliably formed on the side surfaces where the base material layer 10 is exposed, whereby the corrosion resistance of the base material layer 10 can be more improved. Further, the thermal expansion coefficient of the base material layer 10 can be prevented from enlarging, whereby thermal expansion difference between the member 30 made of Al₂O₃ and the material 1 can be prevented from enlarging. Thus, thermal stress generated between the material 1 and the member 30 can be reduced, whereby the package 100 can be prevented from breaking due to thermal stress.

According to one embodiment, the base material layer 10 is made of an Ni-Cr-Co-Fe alloy containing 36-48 mass % of Ni, 6-10 mass % of Cr, 6-18 mass % of Co and Fe. Thus, the thermal expansion coefficient of the base material layer 10 can be prevented from enlarging, whereby thermal expansion difference between the base 31 of the member 30 made of alumina and the material 1 can be prevented from enlarging. Thus, thermal stress generated between the material 1 and the member 30 can be reduced, whereby the package 100 can be prevented from breaking due to thermal stress.

According to one embodiment, Ni excellent in corrosion resistance is further sufficiently contained in the surface layers 11 and 12 when the surface layers 11 and 12 are made of an Ni-Cu alloy containing at least 60 mass % of Ni, whereby not only the corrosion resistance but also the oxidation resistance can be effectively improved in the surface layers 11 and 12. Thus, the surface layers 11 and 12 can be reliably prevented from oxidation also in a case where heat treatment is performed in the atmosphere. Further, the melting point of the surface layer 11 can be lowered as compared with a case where the surface layer 11 is made of Ni or a case where the same is made of another Ni alloy, whereby the temperature at the time of the seam welding of the material 1 and the member 30 can be lowered. Thus, heat applied to the crystal unit 20 can be reduced, and thermal stress generated between the material 1 and the member 30 can be reduced.

According to one embodiment, the surface layers 11 and 12 have the thicknesses t3 and t4 of approximately 3 µm respectively so that the thickness t3 of the surface layer 11 necessary for bonding the surface layer 11 with respect to the member 30 can be sufficiently ensured, whereby hermetic sealing of the package 100 for containing an electronic component can be more prevented from becoming difficult. Further, the ratio of the surface layer 11 not contributing to the bonding can be sufficiently reduced.

According to one embodiment, the surface layers 11 and 12 arranged on the lower surface 1a and the upper surface 1b of the material 1 respectively are made of the same metallic material, whereby the front and rear sides of the material 1 may not be distinguished from each other. Thus, workability in the bonding between the material 1 and the member 30 can be more improved.

According to one embodiment, the material 1 preferably consists of a three-layer clad material constituted of the base material layer 10 made of an Ni-Cr-Fe alloy and the surface layers 11 and 12. More preferably, the base material layer 10 is made of an Ni-Cr-Fe alloy containing 6-10 mass % of Cr. In this case, the time (tact time) necessary for manufacturing one material 1 can be reliably prevented from lengthening while reliably ensuring the corrosion resistance of the material 1 by setting the content of Cr in the base material layer 10 to at least 1 mass %.

According to one embodiment, the surface layer 11 arranged on the side of the lower surface 1a of the material 1 is configured to function as the bonding layer molten when seam-welded with respect to the member 30, whereby the material 1 including the surface layer 11 functioning as the bonding layer and the member 30 can be easily bonded to each other by seam welding.

### (Examples)

A corrosion resistance test of materials 1 conducted to confirm effects of the aforementioned embodiment, a seam welding test of the materials 1 and members 30, leak tests and reliability tests of present packages, a corrosion resistance test and an oxidation resistance test of Ni-Cu alloys constituting surface materials of the materials 1 and study of base material layers are now described with reference to Figs. 2 and 5-15.

### (Corrosion Resistance Test)

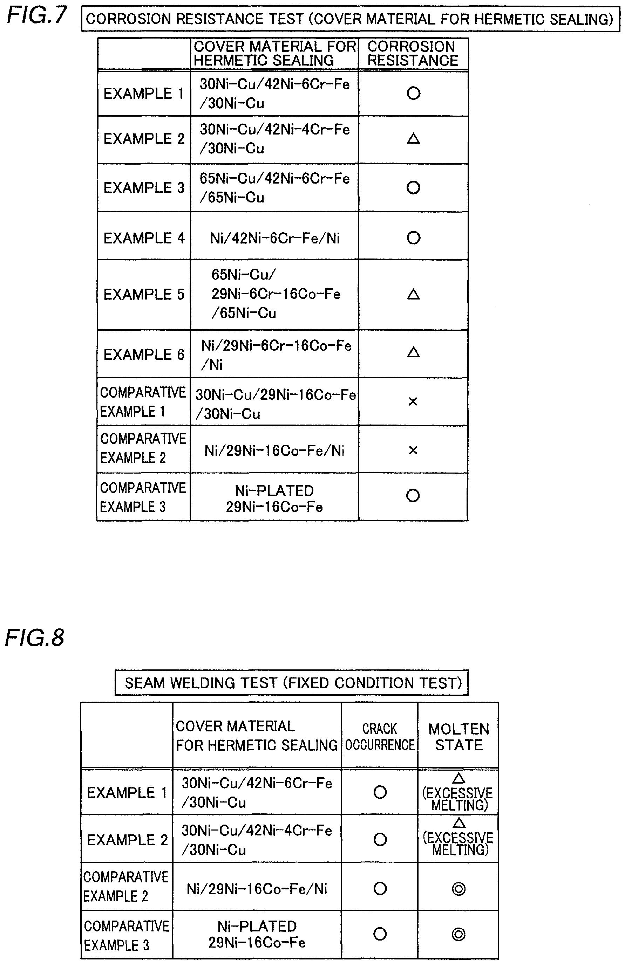

In the corrosion resistance test described below, materials 1 consisting of three-layer clad materials constituted of base material layers 10 made of 42Ni-Cr-Fe alloys and surface layers 11 and 12 made of Ni-Cu alloys (Examples 1-3) or Ni (Example 4, not according to the claimed invention) were employed as Examples 1-4 corresponding to the present material 1 (see Fig. 2), as shown in Fig. 7. Further, materials 1 consisting of three-layer clad materials constituted of base material layers 10 made of 29Ni-6Cr-16Co-Fe alloys and surface layers 11 and 12 made of Ni-Cu alloys (Example 5) or Ni (Example 6, not according to the claimed invention) were employed as Examples 5 and 6 corresponding to the present material 1 (see Fig. 2).

In Example 1, a material 1 (30Ni-Cu/42Ni-6Cr-Fe/30Ni-Cu) consisting of a three-layer clad material constituted of a base material layer 10 made of a 42Ni-6Cr-Fe alloy containing 42 mass % of Ni, 6 mass % of Cr and Fe and surface layers 11 and 12 made of a 30Ni-Cu alloy containing 30 mass % of Ni and 70 mass % of Cu was employed.

In Example 2, a material 1 (30Ni-Cu/42Ni-4Cr-Fe/30Ni-Cu) including a base material layer 10 made of a 42Ni-4Cr-Fe alloy containing 42 mass % of Ni, 4 mass % of Cr and Fe was employed. Thus, the content of Cr was lower in the base material layer 10 of Example 2 than in the base material layer 10 of Example 1.

In Example 3, a material 1 (65Ni-Cu/42Ni-6Cr-Fe/65Ni-Cu) including surface layers 11 and 12 made of a 65Ni-Cu alloy containing 65 mass % of Ni and Cu was employed. Thus, the content of Ni was higher in the surface layers 11 and 12 of Example 2 than in the surface layers 11 and 12 of Example 1.

In Example 4 (not according to the claimed invention), a material 1(Ni/42Ni-6Cr-Fe/Ni) including surface layers 11 and 12 made of Ni was employed. Thus, no Ni-Cu alloy containing Cu was employed in the surface layers 11 and 12 of Example 4.

In Example 5, a material 1 (65Ni-Cu/29Ni-6Cr-16Co-Fe/65Ni-Cu) including a base material layer 10 made of a 29Ni-6Cr-16Co-Fe alloy containing 29 mass % of Ni, 6 mass % of Cr, 16 mass % of Co and Fe and surface layers 11 and 12 made of a 65Ni-Cu alloy was employed.

In Example 6 (not according to the claimed invention), a material 1 (Ni/29Ni-6Cr-16Co-Fe/Ni) including a base material layer 10 made of a 29Ni-6Cr-16Co-Fe alloy and surface layers 11 and 12 made of Ni was employed.

A material 1 (30Ni-Cu/29Ni-16Co-Fe/30Ni-Cu) consisting of a three-layer clad material constituted of a base material layer made of an Fe-based alloy (29Ni-16Co-Fe alloy, the so-called Kovar) containing 29 mass % of Ni, 16 mass % of Co and Fe while containing no Cr and a pair of surface layers made of a 30Ni-Cu alloy was employed as comparative example 1.

Further, a material 1 (Ni/29Ni-16Co-Fe/Ni) consisting of a three-layer clad material constituted of a base material layer made of a 29Ni-16Co-Fe alloy and a pair of surface layers made of Ni was employed as comparative example 2. In addition, a material 1 (Ni-plated 29Ni-16Co-Fe) prepared by performing Ni plating on the whole surface of a base material layer made of a 29Ni-16Co-Fe alloy was employed as comparative example 3.

The materials 1 of Examples 1-6 and comparative examples 1-3 were formed to have lengths of 2.3 mm in the longitudinal direction (X direction), lengths of 1.8 mm in the short-side direction (Y direction) and thicknesses of 80 µm in the thickness direction (Z direction). The thicknesses of the base material layers of the materials 1 of Examples 1-6 and comparative examples 1 and 2 were 74 µm, and the thicknesses of the pairs of surface layers were equally 3 µm. The thickness of the base material layer of the material 1 of comparative example 3 was 74 µm, and the thickness of the Ni-plated layer was 3 µm.

A salt spray test was conducted with respect to the materials 1 of Examples 1-6 and comparative examples 1-3 in accordance with JIS C60068-2-11 under conditions of a temperature of 35 ± 2°C, a salt concentration of 5 ± 1 mass % and a pH of at least 6.5 and not more than 7.2 for 48 hours. Then, the extents of corrosion in the materials 1 were observed.

Referring to Fig. 7, o marks (circular marks) were put on cases where corrosion was hardly confirmable in the materials 1 also after termination of the salt spray test (after a lapse of 48 hours). Further, Δ marks (triangular marks) were put on cases where slight corrosion was confirmed in the vicinity of peripheral edge portions of the materials 1 after the termination of the salt spray test, notwithstanding that the corrosion was at degrees unproblematic in practice. In addition, X marks (x marks) were put on cases where remarkable corrosion was confirmed in the vicinity of peripheral edge portions of the materials 1 after a lapse of 24 hours.

As shown in Fig. 7, the extents of corrosion in the materials 1 of Examples 1-6 employing the Ni-Cr-Fe alloys or the Ni-Cr-Co-Fe alloys as the base material layers 10 were degrees unproblematic in practice, and it has been proved that the materials 1 have sufficient corrosion resistance. This is conceivably because passive state films mainly consisting of Cr₂O₃ were sufficiently formed on portions (side surfaces) where the base material layers 10 were exposed in the materials 1 of Examples 1-6. Further, corrosion was hardly confirmable in the materials 1 of Examples 1, 3 and 4 employing the 42Ni-6Cr-Fe alloys as the base material layers 10. Thus, it has been confirmable that corrosion resistance can be sufficiently improved up to a degree having corrosion resistance equivalent to that of the material 1 of comparative example 3 made of the Ni-plated 29Ni-16Co-Fe alloy, by employing the 42Ni-6Cr-Fe alloy as the base material layer 10. This is conceivably because the passive state films mainly consisting of Cr₂O₃ were sufficiently formed on the portions (side surfaces) where the base material layers 10 were exposed in the materials 1 of Examples 1, 3 and 4.

In the materials 1 of comparative examples 1 and 2 employing the 29Ni-16Co-Fe alloys as the base material layers, on the other hand, remarkable corrosion was confirmed in the vicinity of the peripheral edge portions of the materials 1 after a lapse of 24 hours. This is conceivably because the 29Ni-16Co-Fe alloys were corroded from side surfaces where the base material layers were exposed in the materials 1 of comparative examples 1 and 2. Thus, it has been confirmable that the corrosion resistance is insufficient in the case of employing the 29Ni-16Co-Fe alloy as the base material layer.

Thus, it has been proved as preferable to make the Ni-Cr-Fe alloy and the Ni-Cr-Co-Fe alloy contain at least 6 mass % of Cr, to improve the corrosion resistance of the Ni-Cr-Fe alloys. In the materials 1 of Examples 2, 5 and 6, the extents of corrosion were obviously smaller than those in the materials 1 of comparative examples 1 and 2. In other words, it has been confirmable as possible to improve the corrosion resistance by employing the alloy containing Cr as the base material layer than in the case of employing the 29Ni-16Co-Fe alloy as the base material layer.

### (Seam Welding Test)

In the seam welding test of the cover materials 1 and the electronic component containing members 30 described below, the same cover materials 1 as the aforementioned Examples 1 and 2 and comparative examples 2 and 3 were employed.

The materials of Examples 1 and 2 and comparative examples 2 and 3 and members 30 shown in Fig. 5 were seam-welded by employing a semiautomatic seam welding machine 50 (NAW-1105C, by Nippon Avionics Co., Ltd.), as shown in Fig. 6. More specifically, the pair of roller electrodes 50a were moved in the X direction or the Y direction at a prescribed welding speed along the peripheral edge portions of the cover materials 1 while feeding current from the welding source 50b at a prescribed output under a nitrogen atmosphere. Thus, the cover materials 1 and the members 30 were welded to each other.

First, seam welding of the cover materials 1 of Examples 1 and 2 and comparative examples 2 and 3 and the members 30 was performed in a state (basic conditions) setting the output of the semiautomatic seam welding machine 50 to a prescribed reference value and setting the welding speed to 10 mm/sec (fixed condition test). These basic conditions are ordinary conditions at a time of welding the material 1 (Ni-plated 29Ni-16Co-Fe alloy) according to comparative example and the member 30 to each other.

Then, the presence or absence of occurrence of cracks resulting from thermal stress caused by heat at the time of the seam welding and molten states in the surface layers on the sides of the members 30 were observed. Referring to Fig. 8, o marks (circular marks) were put on cases where occurrence of cracks was not confirmable as evaluation of the presence or absence of occurrence of cracks. Further, X marks (x marks) were put on cases where occurrence of cracks was confirmable.

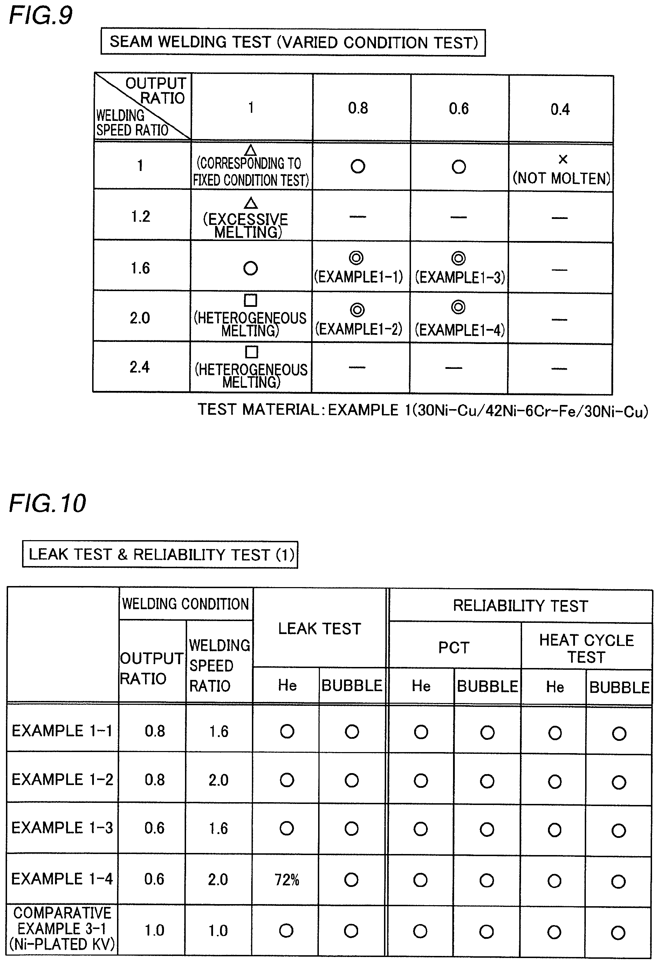

Referring to Figs. 8 and 9, ⊚ marks (double circular marks) were put on cases where the surface layers were homogeneously molten neither too much nor too little in bonded regions of the surface layers of the cover materials 1 and the members 30 as evaluation of the molten states. Further, ○ marks (circular marks) were put on cases where the surface layers were molten neither too much nor too little while the same were slightly heterogeneously molten in the bonded regions. In addition, Δ marks (triangular marks) were put on cases where the surface layers were excessively molten to cover the side surfaces of the materials 1 (cases of excess melting). Further, □ marks (square marks) were put on cases where portions sufficiently molten and portions not sufficiently molten were heterogeneously present in the surface layers in the bonded regions (cases of heterogeneous melting). Further, a X mark (x mark) was put on a case where the surface layers were not sufficiently molten in the bonded regions.

As shown in Fig. 8, occurrence of cracks was not confirmable in any one of Examples 1 and 2 and comparative examples 2 and 3 as results of the fixed condition test. This is so conceivable that thermal stress resulting from heat at the time of the seam welding was sufficiently small since the difference between the thermal expansion coefficients of the electronic component containing member and the electronic component containing member was sufficiently small and no cracks occurred as a result in any one of Examples 1 and 2 and comparative examples 2 and 3. From this, it has been confirmable that occurrence of cracks can be prevented and the packages 100 can be prevented from breaking as a result also in the case of performing the seam welding by employing the materials 1 including the base material layers 10 made of the 42Ni-Cr-Fe alloys according to Examples 1 and 2, similarly to the case of performing the seam welding by employing the materials 1 including the base material layers made of the 29Ni-16Co-Fe alloys of comparative examples 2 and 3.

In Examples 1 and 2, melting of the surface layers became excessive, dissimilarly to comparative examples 2 and 3. With respect to this, the following reasons are conceivable. In other words, the specific resistance (34 µΩ/cm) of the 30Ni-Cu alloys constituting the surface layers 11 of Examples 1 and 2 is larger than the specific resistance (8.5 µΩ/cm) of Ni constituting the surface layers of comparative examples 2 and 3, and hence the quantities of heat generated in the bonded regions of the materials 1 and members 30 are larger in Examples 1 and 2 than in comparative examples 2 and 3. Further, the melting point (about 1200°C) of the 30Ni-Cu alloys is lower than the melting point (about 1450°C) of Ni, and hence the surface layers are molten at lower temperatures in Examples 1 and 2 than in comparative examples 2 and 3. As results of these, the temperatures of the surface layers not only in the bonded regions but also in the vicinity thereof ascend beyond the melting point, due to the large quantities of heat generated in the bonded regions of the materials 1 and the members 30. Consequently, the surface layers were conceivably excessively molten.

From this, it has been proved that seam welding with the members 30 is possible with smaller outputs and at higher welding speeds in the materials 1 of Examples 1 and 2 including the surface layers 11 made of the 30Ni-Cu alloys.

Then, seam welding of the material 1 of Example 1 and the member 30 was performed while varying the output and the welding speed (varied condition test). At this time, the output under the aforementioned basic conditions was set to 1 (prescribed reference value), and the output ratio in the semiautomatic seam welding machine 50 was varied to 1, 0.8, 0.6 and 0.4 times as much as the prescribed reference value. Further, the welding speed under the aforementioned basic conditions was set to 1 (10 mm/sec), and the welding speed ratio in the semiautomatic seam welding machine 50 was varied to 1 (10 mm/sec), 1.2 (12 mm/sec), 1.6 (16 mm/sec), 2.0 (20 mm/sec) and 2.4 (24 mm/sec).

Then, molten states in the surface layer 11 of the material 1 on the side of the member 30 were observed. Evaluation of the molten states was performed similarly to the aforementioned fixed condition test.

In the case of varying the welding speed ratio in the state fixing the output ratio of the semiautomatic seam welding machine 500 to 1, melting of the surface layer 1 consisting of the 30Ni-Cu alloy became excessive in the cases where the welding speed ratio was 1 and 1.2 as results of the varied condition test, as shown in Fig. 9. This is conceivably because the output of the semiautomatic seam welding machine 50 was too large, and a time remaining in prescribed bonded regions was too long. In the cases where the welding speed ratio was 2.0 and 2.4, however, it became such a state that sufficiently molten portions and insufficiently molten portions were heterogeneously present in the surface layer 11 consisting of the 30Ni-Cu alloy. These are conceivably because the output of the semiautomatic seam welding machine 50 was too large, and the time remaining

In the case where the output ratio of the semiautomatic seam welding machine 50 was 1 and the welding speed ratio was 1.6, however, the surface layer 11 was molten neither too much nor too little, although the same was slightly heterogeneously molten. This is conceivably because the time remaining in the prescribed bonded regions was appropriate.

Also in the cases where the welding speed ratio of the semiautomatic seam welding machine 50 was 1 and the output ratio was 0.8 and 0.6, the surface layer 11 was molten neither too much nor too little, although the same was slightly heterogeneously molten. This is conceivably because the output of the semiautomatic seam welding machine 50 was so low that the quantity of heat generated in the bonded regions of the material 1 and the member 30 was reduced. In the case where the welding speed ratio of the semiautomatic seam welding machine 50 was 1 and the output ratio was 0.4, on the other hand, the surface layer 11 was not sufficiently molten in the bonded regions. This is conceivably because the output of the semiautomatic seam welding machine 50 was too low.

In the case where the welding speed ratio of the semiautomatic seam welding machine 50 was 0.8 and the welding speed ratio was 1.6 or 2.0, and in the case where the welding speed ratio was 0.6 and the welding speed ratio was 1.6 or 2.0, the surface layer 11 was homogeneously molten neither too much nor too little in the bonded regions. Thus, it has been proved as possible to bring melting of the surface layer 11 into a homogeneous state neither too much nor too little when the output ratio of the semiautomatic seam welding machine 50 is at least 0.6 and not more than 0.8 and the welding speed ratio is at least 1.6 and not more than 2.0 in the case of employing the cover material 1 for hermetic sealing according to Example 1.

### (Leak Test and Reliability Test of Package for Containing Electronic Component)

In the leak tests and the reliability tests of packages 100 for containing electronic components described below, hermetic properties of the packages 100 were confirmed by employing a plurality of packages 100 prepared by employing the materials 1 of Examples 1, 3 to 6 (not according to the claimed invention) and comparative example 3 in the aforementioned seam welding test (varied condition test).

At this time, a package 100 seam-welded under such conditions that the output ratio of the semiautomatic seam welding machine 50 was 0.8 and the welding speed ratio was 1.6 was employed as Example 1-1 in Example 1 (30Ni-Cu/42Ni-6Cr-Fe/30Ni-Cu). Further, a package 100 seam-welded under such conditions that the output ratio was 0.8 and the welding speed ratio was 2.0 was employed as Example 1-2. In addition, a package 100 seam-welded under such conditions that the output ratio was 0.6 and the welding speed ratio was 1.6 was employed as Example 1-3. Further, a package 100 seam-welded under such conditions that the output ratio was 0.6 and the welding speed ratio was 2.0 was employed as Example 1-4.

In Example 3 (65Ni-Cu/42Ni-6Cr-Fe/65Ni-Cu), Example 4 (Ni/42Ni-6Cr-Fe/Ni (not according to the claimed invention)), Example 5 (65Ni-Cu/29Ni-6Cr-16Co-Fe/65Ni-Cu), Example 6 (Ni/29Ni-6Cr-16Co-Fe/Ni(not according to the claimed invention)) and comparative example 3 (Ni-plated 29Ni-16Co-Fe), packages 100 seam-welded under such a condition that the output ratio of the semiautomatic seam welding machine 50 was 1.0 were employed as Examples 3 to 6 (comparative example 3)-1 respectively. Further, packages 100 seam-welded under such a condition that the output ratio of the semiautomatic seam welding machine 50 was 0.8 were employed as Examples 3-6 (comparative example 3)-2. In addition, packages 100 seam-welded under such a condition that the output ratio of the semiautomatic seam welding machine 50 was 0.6 were employed as Examples 3 to 6 (comparative example 3)-3. In all of Examples 3 to 6 and comparative example 3, the welding speed ratio was set to 1.0.

### (Leak Test)

As the leak tests, an He leak test for detecting minute leaks and a bubble leak test for detecting large leaks were conducted in accordance with JIS C60068-2-17. In the He leak test, an He introducer was brought into a decompressed state by degassing, in a state arranging the packages 100 of Examples 1 and 3 to 6 (comparative example 3)-1, Examples 1 and 3 to 6 (comparative example 3)-2, Examples 1 and 3 to 6 (comparative example 3)-3 and Example 1-4 in the He introducer. Thereafter He was introduced into the He introducer to reach 0.4 MPa (pressurized state), and the He introducer was thereafter held in the pressurized state for 1 hour. In a case where no hermetic sealing is performed in any package 100 at this time, He is introduced into the package 100. Thereafter the presence or absence of leaks of He was measured by arranging the packages 100 taken out of the introducer in a leak tester. In a case where He is introduced into any package for containing an electronic component, He is detected in the leak tester. Consequently, it is detected that minute holes are present in the package 100 and no hermetic sealing is performed.

In the bubble leak test, whether or not air bubbles (bubbles) came from the packages 100 was observed by introducing the packages 100 of Examples 1 and 3-6 (comparative example 3)-1, Examples 1 and 3 to 6 (comparative example 3)-2, Examples 1 and 3 to 6 (comparative example 3)-3 and Example 1-4 into a fluorine-based inactive liquid of 125°C for 30 seconds. In this bubble leak test, large holes hard to detect in the He leak test are detected.

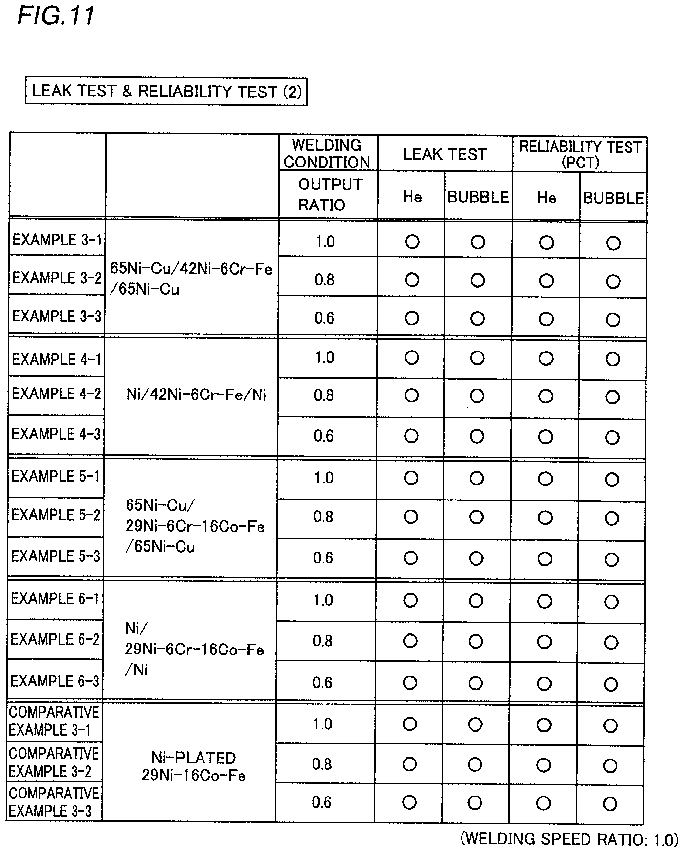

Referring to Figs. 10 and 11, ○ marks (circular marks) were put on cases where no leaks were confirmable in all packages 100 as evaluation of the leak test. In a case where leaks were confirmed in packages 100, the ratio of packages 100 (acceptable products) in which no leaks were confirmable among the packages 100 subjected to the leak test was recorded.

As shown in Figs. 10 and 11, no leaks of He were detectable in the He leak test except for Example 1-4 as results of the leak test. In the bubble leak test, further, no bubbles were observable in all of Examples 1 and 3-6 and comparative example 3. Thus, it has been confirmable that hermetic sealing was completely performed in the packages 100 of Examples 1 and 3 to 6-1, Examples 1 and 3 to 6-2 and Examples 1 and 3 to 6-3.

In Example 1-4, on the other hand, leaks of He were detected in 28 % (= 100 % - 72 %) of packages 100 for containing electronic components among the packages 100 subjected to the leak test. Thus, it has been proved that packages in which minute bubbles are present and hermetic sealing is not completely performed are present in Example 1-4. This is conceivably because the output was smaller than in Examples 1-1 and 1-2 and the welding speed was faster than in Examples 1-1 and 1-3 and hence not sufficiently molten portions easily occurred in the bonded regions of the surface layers 11 in Example 1-4. Thus, it is conceivably appropriate to set the output ratio of the semiautomatic seam welding machine 50 to 0.6 and to set the welding speed ratio to 1.6-2.0 or to set the output ratio to 0.6 and to set the welding speed ratio to 1.6, to completely perform hermetic sealing in the package 100 while bringing melting of the surface layer 11 into a homogeneous state neither too much nor too little.

In Examples 3 to 6 in which the contents of Ni in the surface layers 11 are at least 65 %, it has been confirmable that no leaks occur in the case where the welding speed ratio is 1.0 also when the output ratio is reduced. Thus, it has been confirmable as possible to completely perform hermetic sealing in the package 100 while bringing melting of the surface layer 11 into a homogeneous state neither too much nor too little by setting the output ratio to at least 0.6 and setting the welding speed ratio to 1.0 also in a case where the melting point of the surface layer is high due to the fact that the content of Ni is large.

### (Reliability Test)

In the reliability tests, the packages 100 of Examples 1 and 3 to 6 (comparative example 3)-1, Examples 1 and 3 to 6 (comparative example 3)-2, Examples 1 and 3 to 6 (comparative example 3)-3 and Example 1-4 of the acceptable products in which no leaks of He were detected and no bubbles were observed in the aforementioned leak tests were employed. As the reliability tests, pressure cooker tests (PCTs) and heat cycle tests were conducted. On Examples 3 to 6-1, Examples 3 to 6 (comparative example 3)-2 and Examples 3 to 6 (comparative example 3)-3, only the PCTs were conducted.

In the PCTs, the packages 100 of Examples 1 and 3 to 6 (comparative example 3)-1, Examples 1 and 3 to 6 (comparative example 3)-2, Examples 1 and 3 to 6-3 and Example 1-4 were held under conditions (high temperature, high moisture and high pressure conditions) of 120°C, 100 % RH and 0.2 MPa for 96 hours. Thereafter tests similar to the aforementioned leak tests were conducted.

In the heat cycle tests, 1000 cycles were conducted while setting a cycle of holding the packages 100 of Examples 1-1 to 1-4 and comparative example 3-1 at -45°C for 30 minutes and thereafter holding the same at 85°C for 30 minutes as one cycle. Thereafter tests similar to the aforementioned leak tests were conducted.

As shown in Figs. 10 and 11, no leaks of He were detected and no bubbles were observed in all packages 100 of Examples 1 and 3 to 6 (comparative example 3)-1, Examples 1 and 3 to 6 (comparative example 3)-2, Examples 1 and 3 to 6 (comparative example 3)-3 and Example 1-4 of the acceptable products in the leak tests after the PCTs as results of the reliability tests. Also in the leak tests after the heat cycle tests, no leaks of He were detected and no bubbles were observed in all packages 100 of Examples 1-1 to 1-4 and comparative example 3-1 of the acceptable products. Thus, the packages 100 of Examples 1 and 3 to 6 of the acceptable products are conceivably sufficiently high in reliability in relation to hermetic properties.

### (Corrosion Resistance Test of Ni-Cu Alloy)

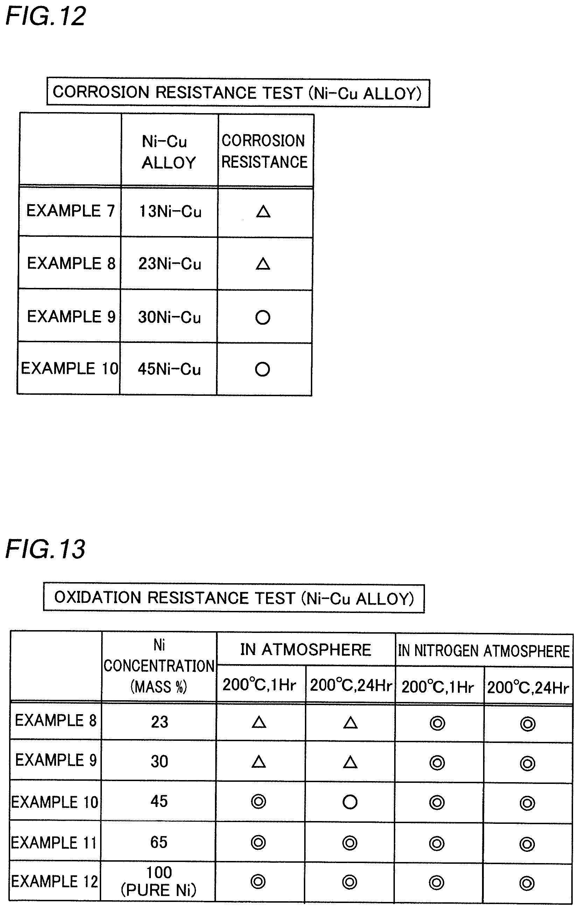

In order to confirm corrosion resistance of the Ni-Cu alloys constituting the surface materials of cover materials 1, the corrosion resistance test of the Ni-Cu alloys was conducted. In the corrosion resistance test of the Ni-Cu alloys described below, Ni-Cu alloys in which the contents of Ni and Cu were varied were employed, as shown in Fig. 12.

More specifically, a 13Ni-Cu alloy containing 13 mass % of Ni and 87 mass % of Cu was employed as Example 7 (comparison, not according to the claimed invention). Further, a 23Ni-Cu alloy containing 23 mass % of Ni and 77 mass % of Cu was employed as Example 8 (comparison, not according to the claimed invention). In addition, a 30Ni-Cu alloy containing 30 mass % of Ni and 70 mass % of Cu was employed as Example 9. Further, a 45Ni-Cu alloy containing 45 mass % of Ni and 55 mass % of Cu was employed as Example 10.

Plate materials of 10 mm by 10 mm by 500 µm (thickness) were employed as the Ni-Cu alloy materials of Examples 7-10.

Then, the corrosion resistance test was conducted with respect to the Ni-Cu alloy materials according to Examples 7-10. More specifically, a salt spray test was conducted in accordance with JIS C60068-2-11, similarly to the aforementioned corrosion test of the materials 1. Then, the extents of corrosion in the Ni-Cu alloy materials were observed. Referring to Fig. 12, ○ marks (circular marks) were put on cases where corrosion was hardly confirmable in the Ni-Cu alloys as evaluation of the corrosion resistance. Further, Δ marks (triangular marks) were put on cases where slight corrosion was confirmed in the Ni-Cu alloys. In addition, × marks (x marks) were put on cases where remarkable corrosion was confirmed in the Ni-Cu alloys.

As shown in Fig. 12, slight corrosion was confirmed in the Ni-Cu alloys in (comparative) Examples 7 and 8 in which the contents of Ni are not more than 23 mass %. In Examples 9 and 10 in which the contents of Ni are at least 30 mass %, however, corrosion was hardly confirmable in the Ni-Cu alloys. Thus, it has been proved as preferable to employ an Ni-Cu alloy containing at least 30 mass % of Ni to improve the corrosion resistance of the material 1. The melting point of an Ni-Cu alloy increases as the content of Ni enlarges, and hence an Ni-Cu alloy whose Ni content is at least 30 mass % and close to 30 mass % is preferable from the point that it is possible to lower the melting point while having sufficient corrosion resistance.

### (Oxidation Resistance Test of Ni-Cu Alloy)

Further, the oxidation resistance test of Ni-Cu alloys was conducted in order to confirm oxidation resistance of the Ni-Cu alloys constituting surface materials of materials 1. In the oxidation resistance test of the Ni-Cu alloys described below, plate materials of Ni-Cu alloys in which the contents of Ni and Cu were varied or a plate material of Ni was employed, as shown in Fig. 13.

More specifically, a plate material of a 65Ni-Cu alloy containing 65 mass % of Ni and 35 mass % of Cu was employed as Example 11, in addition to the plate material of Example 8 (23Ni-Cu alloy; not according to the claimed invention), the plate material of Example 9 (30Ni-Cu alloy) and the plate material of Example 10 (45Ni-Cu alloy) employed in the aforementioned corrosion resistance test. Further, a plate material of pure Ni containing no Cu was employed as Example 12.

Then, the oxidation resistance test was conducted with respect to the plate materials of the Ni-Cu alloys (pure Ni, not according to the claimed invention)) of Examples 8-12. More specifically, the extents of discoloration on the plate material surfaces resulting from oxidation were observed by performing heating in the atmosphere at 200°C for a prescribed time (one hour or 24 hours). Further, oxygen concentrations in the surfaces after the heat treatment were measured by EDX. As a comparative experiment, a test similar to the aforementioned one in the atmosphere was conducted also in a nitrogen atmosphere.

Referring to Fig. 13, ⊚ marks (double circular marks) were put on cases where the surfaces of a metallic color (the so-called silver) remained substantially unchanged. Further, ○ marks (circular marks) were put on cases where no remarkable discoloration occurred although the surfaces of the metallic color were slightly colored. In addition, Δ marks (triangular marks) were put on cases where the surfaces of the metallic color were remarkably discolored to ocher or black.

As shown in Fig. 13, no discoloration was confirmable at all in the nitrogen atmosphere in any one of Examples 8-12. In other words, it has been confirmable that no discoloration occurs in the nitrogen atmosphere in which no oxygen is present. In the atmosphere in which oxygen is present, however, remarkable discoloration was confirmed in the Ni-Cu alloys in Examples 8 and 9 in which the Ni contents are not more than 30 mass %, in both of the case of heating the same at 200°C for one hour and the case of heating the same at 200°C for 24 hours. In Examples 11 and 12 in which the Ni contents are at least 65 mass %, however, discoloration resulting from oxidization was hardly confirmable in the Ni-Cu alloys in both of the case of heating the same at 200°C for one hour and the case of heating the same at 200°C for 24 hours. Thus, it has been proved as preferable to employ an Ni-Cu alloy containing at least 65 mass % of Ni in order to remarkably improve the oxidation resistance of the material 1.

In the atmosphere, discoloration resulting from oxidation was hardly confirmable in Example 10 in which the Ni content is 45 mass % in the case of heating the same at 200°C for one hour, while slight discoloration was confirmed in the Ni-Cu alloy in the case of heating the same at 200°C for 24 hours. Thus, it has been proved as preferable to employ an Ni-Cu alloy containing at least 45 mass % of Ni in order to improve the oxidation resistance of the material 1 to a certain degree.

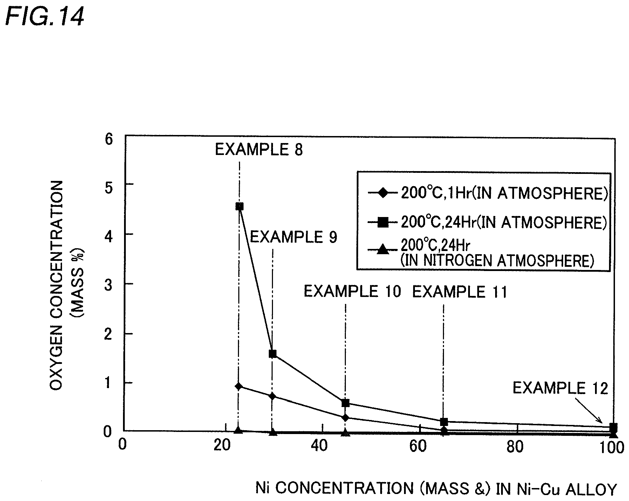

Also from results of the EDX shown in Fig. 14, it has been confirmable that the oxygen concentration in the plate material surface after the heat treatment reduces by enlarging the content of Ni. From the graph shown in Fig. 14, the oxygen concentration conceivably becomes not more than about 0.3 mass % when it is the Ni-Cu alloy containing at least 60 mass %, also in a case of heating the Ni-Cu alloy at 200°C for 24 hours. Consequently, it is conceivable that decoloration hardly occurs and it is possible to sufficiently improve oxidation resistance when it is an Ni-Cu alloy containing at least 60 mass % of Ni.

From these, an Ni-Cu alloy containing about 30 mass % of Ni has been preferable in the point that the same has sufficient corrosion resistance and it is possible to lower the melting point, while the same is conceivably not much suitable in a case where visual attractiveness is necessary since the same has low oxidation resistance and is easily discolored. In a case where visual attractiveness is particularly important although the melting point increases, it is conceivably more preferable to employ an Ni-Cu alloy containing about 60 mass % of Ni having remarkable resistance against oxidation and substantially not discolored. In a case where visual attractiveness such as discoloration is necessary to a certain degree, it is conceivably more preferable to employ an Ni-Cu alloy containing Ni in which the content of Ni is about 45 mass %, since discoloration can also be prevented to a certain degree while lowering the melting point.

### (Study of Composition of Base Material Layer based on Thermal Expansion Property)

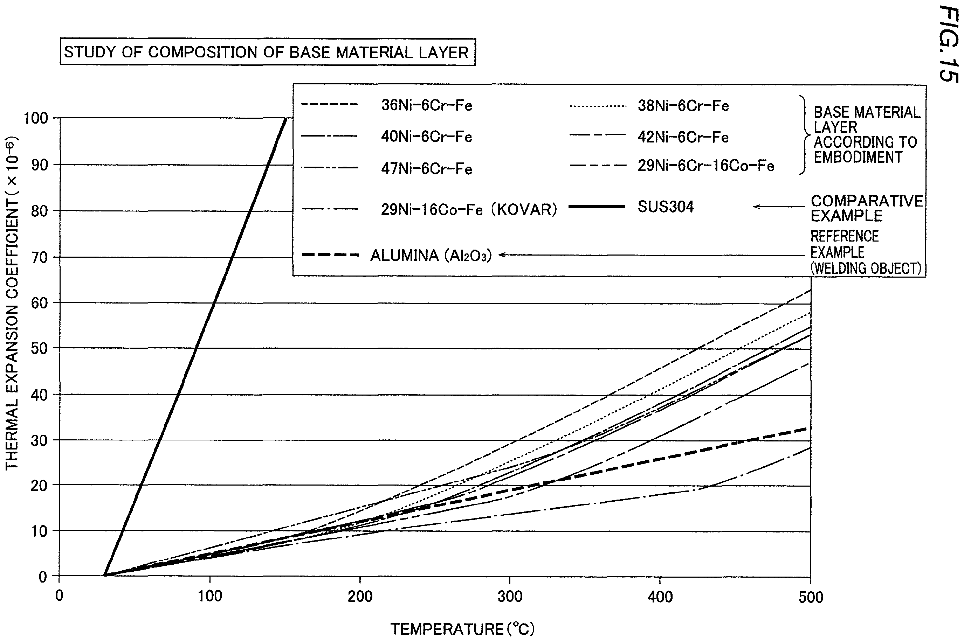

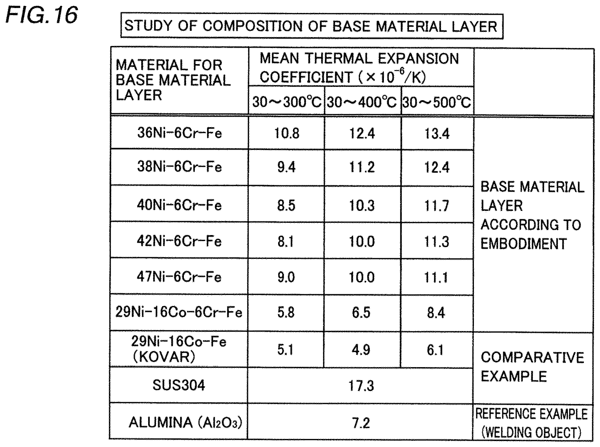

Finally, the compositions of alloys suitable for the base material layer of the present invention were studied on the basis of the thermal expansion coefficients of the Ni-Cr-Fe alloys and the Ni-Cr-Co-Fe alloy constituting the base material layers 10 employed for the cover materials 1 for hermetic sealing. The Ni-Cr-Fe alloys and the Ni-Cr-Co-Fe alloy having thermal expansion coefficients close to the thermal expansion coefficient of alumina (Al₂O₃) constituting the welding object (the base 31) in the sealing are conceivably suitable as the base material layer. While Fig. 15 graphically shows changes of thermal expansion coefficients with respect to temperature changes, Fig. 16 shows mean thermal expansion coefficients in prescribed temperature ranges (30-300°C, 30-400°C and 30-500°C).

From the graph shown in Fig. 15, the thermal expansion coefficients were small at any temperature in all of the Ni-Cr-Fe alloys and the Ni-Cr-Co-Fe alloy, which had thermal expansion coefficients close to the thermal expansion coefficient of alumina (Al₂O₃), as compared with the thermal expansion coefficient of SUS304 which is comparative example. From the table shown in Fig. 16, the mean thermal expansion coefficients (at least 5.8 × 10⁻⁶/K and not more than 13.4 × 10⁻⁶/K) were small in any temperature range in all of the Ni-Cr-Fe alloys and the Ni-Cr-Co-Fe alloy, which had mean thermal expansion coefficients close to the mean thermal expansion coefficient (7.2 × 10⁻⁶/K) of alumina (Al₂O₃), as compared with the mean thermal expansion coefficient (17.3 × 10⁻⁶/K) of SUS304 which is comparative example. In other words, the Ni-Cr-Fe alloys and the Ni-Cr-Co-Fe alloy are conceivably more suitable for the base material layer than SUS304.

In the Ni-Cr-Fe alloys, the thermal expansion coefficients reduced as a whole and approximated the thermal expansion coefficient of alumina, as the contents of Ni were enlarged. When the contents of Ni were at least 40 mass %, on the other hand, changes of the thermal expansion coefficients were not much confirmable.

As to the thermal expansion coefficient of the Ni-Cr-Co-Fe alloy (29Ni-6Cr-16Co-Fe alloy), the thermal expansion coefficient became larger than that of the 29Ni-16Co-Fe alloy (the so-called Kovar) containing no Cr at any temperature, while the same became smaller than the thermal expansion coefficients of the Ni-Cr-Fe alloys, and most approximated the thermal expansion coefficient of alumina.

While the mean thermal expansion coefficient of alumina became 7.2 × 10⁻⁶/K in the temperature range of 30-400°C in this experiment, the mean thermal expansion coefficient of alumina is generally included in the range of at least 6.4 × 10⁻⁶/K and not more than 8.1 × 10⁻⁶/K in the temperature range of 30-400°C. Therefore, an alloy close to this range of the mean thermal expansion coefficient of alumina is conceivably suitable for the base material layer. In other words, the Ni-Cr-Fe alloys in which the Ni contents are at least 40 mass % or the Ni-Cr-Co-Fe alloy (29Ni-6Cr-16Co-Fe alloy) is conceivably suitable for the base material layer.

The embodiment and Examples disclosed this time must be considered as illustrative in all points.

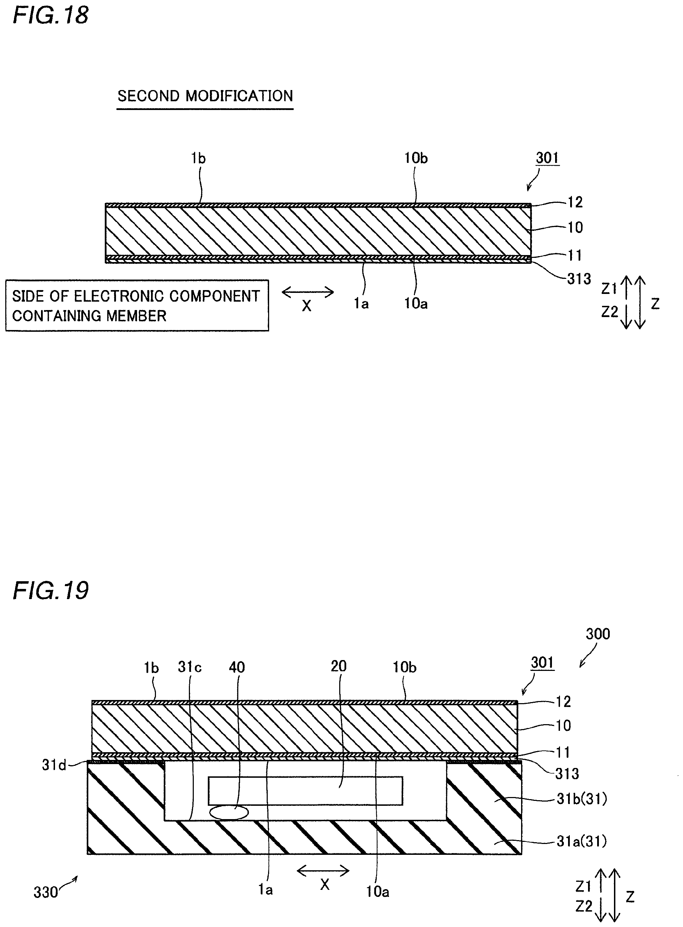

For example, a material 1 may be configured as a material 301 to consist of a four-layer clad material constituted of not only a base material layer 10 and surface layers 11 and 12 pressure-bonded to a lower surface 10a and an upper surface 10b of the base material layer 10 respectively but also a silver solder layer 313 pressure-bonded to the lower surface (on the side of a battery component containing member) of the surface layer 11, as in a modification shown in Figs. 18 and 19. A silver solder material consisting of 72 mass % of Ag and Cu is preferably employed as the silver solder layer 313.

In Fig. 19 a package 300 as a modification of the package 100 is shown, wherein an electronic component containing member 330 consists of only a base 31, and is provided with no sealing ring. The silver solder layer 313 and the base 31 are welded to each other by seam welding or electron beam welding in a state where the silver solder layer 313 of the material 301 and a metallized layer 31d of the base 31 are in contact with each other. At this time, the melting point of the silver solder layer 313 consisting of the silver solder material consisting of 72 mass % of Ag and Cu is about 780°C, and the melting point is lower than that of an Ni-Cu alloy or Ni, whereby it is possible to reduce thermal stress generated at the time of sealing. While weld marks are formed on outer edge portions of the material 301 and the base 31 in the case of performing the seam welding, weld marks are formed on an inner side (the side where a crystal unit 20 is contained) beyond the outer edge portions of the material 301 and the base 31 in the case of performing the electron beam welding.

In the aforementioned modification, the material 301 and a sealing ring can be sealed (brazed/bonded) to each other without providing a silver solder portion on the sealing ring bonded to the material 301, whereby the number of components can be reduced when preparing the package 300.

While the aforementioned embodiment has shown such an example that the material 1 has a thickness t1 of about 80 µm, the present invention is not restricted to this. The thickness of the material 1 is preferably 70-150 µm.

While the aforementioned embodiment has shown such an example that the upper surface 1b of the material 1 is in the form of a planar surface, the present invention is not restricted to this. The peripheral edge portion of the upper surface of the material 1 may be so inclined that the thickness of the material 1 reduces toward the outer edge of the material 1, thereby coinciding with the inclination of the roller electrodes of tapered shapes. Thus, it is possible to enlarge contact areas of the material 1 and the pair of roller electrodes.

While the aforementioned embodiment has shown the example of bonding the material 1 and the member 30 to each other by seam welding which is a sort of resistance welding, the present invention is not restricted to this. For example, the material 1 and the member 30 may be bonded to each other by resistance spot welding which is a sort of resistance welding. Further, the material 1 and the member 30 may be bonded to each other by employing a bonding method other than the resistance welding. For example, the material 1 and the el member 30 may be bonded to each other by electron beam welding employing electron beams. At this time, it is preferable since the surface layers can be easily molten with the electron beams, by preparing the surface layers from an Ni-Cu alloy whose melting point is low.

While the aforementioned embodiment has shown the example of containing the crystal unit 20 in the member 30, the present invention is not restricted to this. For example, a SAW filter (surface acoustic wave filter) may be contained in the member 30.

### Description of Reference Signs

- 1, 201, 301: cover material for hermetic sealing
- 10: base material layer
- 10a: lower surface (one surface)
- 10b: upper surface (another surface)
- 11: surface layer (first surface layer)
- 12: surface layer (second surface layer)
- 20: crystal unit (electronic component)
- 30, 330: electronic component containing member
- 100, 300: package for containing electronic component
- 313: silver solder layer

## Claims

1. A material which is suitable as a cover material [1] for hermetic sealing and is constituted of a three-layer clad material comprising:
(i) a base material layer [10] made of
a Ni-Cr-Fe alloy containing 36-48 mass-% of Ni, 1-10 mass-% of Cr and Fe, or
a Ni-Cr-Co-Fe alloy containing 36-48 mass-% of Ni, 1-10 mass-% of Cr, 6-18 mass-% of Co and Fe;
(ii) a first surface layer [11] made of a Ni-Cu alloy containing ≥ 30 mass% Ni, Cu and unavoidable impurities and bonded to one surface of the base material layer [10]; and
(iii) a second surface layer [12] made of a Ni-Cu alloy containing ≥ 30 mass% Ni, Cu and unavoidable impurities and bonded to the other surface of the base material layer [10;
and the layers [11] and [12] have a thickness of 2-6 µm.

2. The material of claim 1, wherein the alloy of the base material layer [10] contains 6-10 mass % of Cr.

3. The material of claim 1, wherein the base material layer [10] is made of a Ni-Cr-Co-Fe alloy containing 6-18 mass % of Co.

4. The material of claim 1, wherein the Ni-Cu alloy contains ≥ 60 mass %, of Ni.

5. The material of claim 1, wherein the clad material includes a silver solder layer at least bonded onto a surface of one of the surface layers [11, 12].

6. The material of claim 1, wherein the Ni-Cr-Fe alloy contains 6-10 mass % of Cr.

7. The material of claim 3, wherein the clad material is made of a Ni-Cr-Co-Fe alloy containing 1-10 mass % of Cr and 6-18 mass % of Co and Fe.

8. The material of claim 1, wherein one of the surface layers [11, 12] is configured to function as a melting bonding layer with respect to an electronic component containing member.

9. A package [100] suitable for containing an electronic component comprising:
- a member [30] for containing an electronic component; and
- the material of claim 1 as a cover material [1].

10. The package of claim 9, wherein the surface layer [11, 12] of the cover material [1] facing to the side of the electronic component containing member [30] functions as a melting bonding layer with respect to the package for containing an electronic component.

11. The use of the material of any of claims 1-8 as a cover material [1] of a package [100] suitable for containing an electronic component.

## Patentansprüche

1. Material, das als Abdeckmaterial [1] für hermetische Abdichtung geeignet ist und aus einem dreischichtigen plattierten Material besteht, umfassend:
(i) eine Basismaterialschicht [10], hergestellt aus einer Ni-Cr-Fe-Legierung die 36-48 Massen-% Ni, 1-10 Massen-% Cr und Fe enthält, oder
einer Ni-Cr-Co-Fe-Legierung die 36-48 Massen-% Ni, 1-10 Massen-% Cr, 6-18 Massen-% Co und Fe enthält;
(ii) eine erste Oberflächenschicht [11], hergestellt aus einer Ni-Cu-Legierung die ≥ 30 Massen-% Ni, Cu und unvermeidbare Verunreinigung enthält und an eine Oberfläche der Basismaterialschicht [10] gebunden ist; und
(iii) eine zweite Oberflächenschicht [12], hergestellt aus einer Ni-Cu-Legierung die ≥ 30 Massen-% Ni, Cu und unvermeidbare Verunreinigung enthält und an die andere Oberfläche der Basismaterialschicht [10] gebunden ist;
und die Schichten [11] und [12] weisen eine Dicke von 2-6 µm auf.

2. Material gemäß Anspruch 1, wobei die Legierung der Basismaterialschicht [10] 6-10 Massen-% Cr enthält.

3. Material gemäß Anspruch 1, wobei die Basismaterialschicht [10] aus einer Ni-Cr-Co-Fe-Legierung, die 6-18 Massen-% Co enthält, besteht.

4. Material gemäß Anspruch 1, wobei die Ni-Cu-Legierung ≥ 60 Massen-% Ni enthält.

5. Material gemäß Anspruch 1, wobei das plattierte Material eine Silberlotschicht, die mindestens an eine Oberfläche einer der Oberflächenschichten [11, 12] gebunden ist, enthält.

6. Material gemäß Anspruch 1, wobei die Ni-Cr-Fe-Legierung 6-10 Massen-% Cr enthält.

7. Material gemäß Anspruch 3, wobei das plattierte Material aus einer Ni-Cr-Co-Fe-Legierung, die 1-10 Massen-% Cr und 6-18 Massen-% Co und Fe enthält, besteht.

8. Material gemäß Anspruch 1, wobei eine der Oberflächenschichten [11, 12] so konfiguriert ist, dass sie als Schmelzbindungsschicht, in Bezug auf ein elektronisches Bauteil enthaltendes Element, fungiert.

9. Verpackung [100], die geeignet ist ein elektronisches Bauteil zu enthalten, umfassend:
- ein Element [30] zur Aufnahme eines elektronischen Bauteils; und
- das Material gemäß Anspruch 1 als Abdeckmaterial [1].

10. Verpackung gemäß Anspruch 9, wobei die Oberflächenschicht [11, 12] des Abdeckmaterials [1], die der Seite des elektronisches Bauteil-enthaltenden Elements [30] zugewandt ist, als Schmelzbindungsschicht, in Bezug auf die Verpackung zur Aufnahme eines elektronischen Bauteils, fungiert.

11. Verwendung des Materials gemäß mindestens einem der Ansprüche 1-8 als Abdeckmaterial [1] einer Verpackung [100], das zur Aufnahme eines elektronischen Bauteils geeignet ist.

## Revendications

1. Matériau qui est approprié comme matériau de recouvrement [1] pour scellement hermétique et est constitué d'un matériau de gainage à trois couches comprenant :
(i) une couche de matériau de base [10] constituée de
un alliage de Ni-Cr-Fe contenant de 36 à 48 % en masse de Ni, de 1 à 10 % en masse de Cr et de Fe, ou
un alliage de Ni-Cr-Co-Fe contenant de 36 à 48 % en masse de Ni, de 1 à 10 % en masse de Cr, de 6 à 18 % en masse de Co et de Fe ;
(ii) une première couche de surface [11] constituée d'un alliage de Ni-Cu contenant ≥ 30 % en masse de Ni, du Cu et les inévitables impuretés et liée à une surface de la couche de matériau de base [10] ; et
(iii) une seconde couche de surface [12] constituée d'un alliage de Ni-Cu contenant ≥ 30 % en masse de Ni, du Cu et les inévitables impuretés et liée à l'autre surface de la couche de matériau de base [10] ;
et les couches [11] et [12] ont une épaisseur de 2 à 6 µm.

2. Matériau selon la revendication 1, dans lequel l'alliage de la couche de matériau de base [10] contient de 6 à 10 % en masse de Cr.

3. Matériau selon la revendication 1, dans lequel la couche de matériau de base [10] est constituée 'd'un alliage de Ni-Cr-Co-Fe contenant de 6 à 18 % en masse de Co.

4. Matériau selon la revendication 1, dans lequel l'alliage de Ni-Cu contient ≥ 60 % en masse de Ni.

5. Matériau selon la revendication 1, dans lequel le matériau de gainage inclut une couche de brasure à l'argent liée au moins sur une surface d'une des couches de surface [11, 12].

6. Matériau selon la revendication 1, dans lequel l'alliage de Ni-Cr-Fe contient de 6 à 10 % en masse de Cr.

7. Matériau selon la revendication 3, dans lequel le matériau de gainage est constitué d'un alliage de Ni-Cr-Co-Fe contenant de 1 à 10 % en masse de Cr et de 6 à 18 % en masse de Co et de Fe.

8. Matériau selon la revendication 1, dans lequel une des couches de surface [11, 12] est configurée pour faire office de couche de liaison par fusion par rapport à un élément contenant un composant électronique.

9. Boîtier [100] approprié pour contenir un composant électronique, comprenant :
- un élément [30] destiné à contenir un composant électronique ; et
- le matériau selon la revendication 1 à titre de matériau de recouvrement [1].

10. Boîtier selon la revendication 9, dans lequel la couche de surface [11, 12] du matériau de recouvrement [1] orientée vers le côté de l'élément [30] contenant un composant électronique fait office de couche de liaison par fusion par rapport au boîtier destiné à contenir un composant électronique.

11. Utilisation du matériau selon l'une quelconque des revendications 1 à 8 à titre de matériau de recouvrement [1] d'un boîtier [100] approprié pour contenir un composant électronique.
